# EUROPÄISCHE PATENTSCHRIFT

(11) **EP 4 284 637 B1**
(45) Veröffentlichungstag und Bekanntmachung des Hinweises auf die Patenterteilung: **06.11.2024**
(21) Anmeldenummer: 22701179.8
(22) Anmeldetag: 12.01.2022
(51) Int. Cl.: B32B 17/10, B60J 1/00, C08K 3/01

(54) **VERBUNDSCHEIBE MIT VERBESSERTER FARBWIRKUNG**
LAMINATED GLASS WITH IMPROVED COLOUR EFFECT
VITRE COMPOSITE À EFFET DE COULEUR AMÉLIORÉ

(30) Priorität: 28.01.2021 EP 21154014
(43) Veröffentlichungstag der Anmeldung: 06.12.2023
(73) Patentinhaber: Saint-Gobain Glass France, 92400 Courbevoie (FR)
(72) Erfinder: HAGEN, Jan, 53123 Bonn (DE); GIER, Stephan, 66359 Bous (DE); KOELLING, Marc, 52072 Aachen (DE)
(74) Vertreter: Weber, Sophie
(86) Internationale Anmeldenummer: PCT/EP2022/050546
(87) Internationale Veröffentlichungsnummer: WO 2022/161770

(56) Entgegenhaltungen:
- US-A1- 2007 082 219

## Beschreibung

Die Erfindung betrifft eine Verbundscheibe mit verbesserten optischen Eigenschaften, insbesondere einer verbesserten Farbwirkung in der Reflexion, und ein Verfahren zur Herstellung einer solchen Verbundscheibe und deren Verwendung.

Verbundglasscheiben bestehen aus zwei oder mehreren Einzelscheiben und werden mit einer oder mehreren Zwischenschichten bei Hitze und Druck fest miteinander verbunden. Die Zwischenschichten bestehen meist aus thermoplastischen Kunststoffen wie Polyvinylbutyral (PVB) oder Ethylenvinylacetat (EVA).

An die Verglasung von Kraftfahrzeugen werden hohe Anforderungen gestellt. Hinsichtlich der Größe des Sichtbereichs und der strukturellen Stabilität der Scheiben gelten folgende gesetzlichen Vorschriften:
- ECE R 43: "Einheitliche Vorschriften für die Genehmigung des Sicherheitsglases und der Verbundglaswerkstoffe" sowie
- Technische Anforderungen an Fahrzeugteile bei der Bauartprüfung § 22 a StVZO, "Sicherheitsglas".

Diese Vorschriften werden in der Regel durch Verbundglasscheiben erfüllt. Bei der Fertigung der Verbundscheiben wurden bisher thermoplastische Folien, insbesondere Polyvinylbutyral (PVB)-Folien eingesetzt, die einen Brechungsindex aufweisen, der möglichst nahe an dem der verwendeten Außenscheiben und Innenscheiben liegt. Üblicherweise liegt der Brechungsindex der bisher eingesetzten PVB Folien bei ca. 1,48 im sichtbaren Bereich, der gewöhnlich bei einem festen Wert, zum Beispiel bei 500 oder 550 nm angegeben wird. (D. C. Miller, Optical Engineering 50(1), 013003, 2011).

Es ist bekannt, Windschutzscheiben mit transparenten, funktionellen Filmen, beispielsweise mit elektrisch leitfähigen Beschichtungen zu versehen. Diese Beschichtungen können beispielsweise als IR-reflektierende Beschichtungen wirken, um die Erwärmung des Fahrzeuginnenraums zu verringern und dadurch den thermischen Komfort zu verbessern. Die Beschichtungen können aber auch andere Funktionen erfüllen und beispielsweise als beheizbare Beschichtungen verwendet werden, indem sie mit einer Spannungsquelle verbunden werden, so dass ein Strom durch die Beschichtung fließt. Geeignete Beschichtungen enthalten beispielsweise leitfähige, metallische Schichten auf Basis von Silber. Da diese Schichten korrosionsanfällig sind, ist es üblich, sie auf die der Zwischenschicht zugewandten Oberfläche der Außenscheibe oder der Innenscheibe aufzubringen, so dass sie keinen Kontakt zur Atmosphäre haben. Sogenannte Low-E-Beschichtungen werden aber auch auf der Innenfläche der Innenscheibe aufgebracht. Silberhaltige transparente Beschichtungen sind beispielsweise bekannt aus WO 03/024155, US2007/0082219 A1, US2007/0020465 A1, WO2013/104438 oder WO2013/14439.

In der WO2019/206493 A1 ist eine Verbundscheibe mit einer elektrisch leitfähigen Beschichtung und einer Antireflexionsbeschichtung als Projektionsfläche für ein Head-Up-Display beschrieben.

Die WO2012/052315 beschreibt eine transparente Verbundscheibe mit elektrisch beheizbarer Beschichtung, in der mindestens eine elektrisch beheizbare Beschichtung mindestens vier übereinander angeordnete funktionelle Schichten aufweist. Jede funktionelle Schicht umfasst dabei mindestens eine Schicht optisch hochbrechenden Materials mit einem Brechungsindex ≥ 2,1. Die funktionelle Schicht weist mehrere silberhaltige Schichten und dazwischen angeordnete Anpassungs- und Glättungsschichten auf. Die transparente Scheibe weist eine Gesamttransmission von > 70 % auf.

In der DE 202019102388 U1 ist eine Verbundscheibe umfassend eine transparente elektrisch leitfähige Beschichtung beschrieben, die zusätzlich ein dielektrisches Übergitter aufweist. Das Übergitter ist bevorzugt aus alternierend angeordneten Schichten mit unterschiedlichen Brechungsindices gebildet und besteht dabei aus einer Vielzahl von Einzelschichten, wobei Schichten mit hohem Brechungsindex (bevorzugt größer 1,8 bei einer Wellenlänge von 550 nm) und Schichten mit niedrigem Brechungsindex (bevorzugt kleiner 1,8 bei einer Wellenlänge von 550 nm) alternierend übereinander angeordnet sind. Das Übergitter führt dabei zu einer Herabsetzung der Transmission im Spektralbereich von 400 nm bis 500 nm. Der Bereich mit dem Übergitter ist außerhalb des zentralen Sichtbereichs der Verbundscheibe angeordnet, so dass die Transmissionsverringerung keine negativen Auswirkungen für die Insassen des Fahrzeugs hat, insbesondere hinsichtlich der Gesamttransmission und eines etwaigen Farbstichs.

Bei dem Einsatz funktioneller Filme in Verbundscheiben muss der Fachmann bei der Gestaltung der Beschichtungen insbesondere im Fahrzeugbau verschiedenste Anforderungen beachten. Durch die typischerweise metallhaltigen leitfähigen Schichten der funktionellen Filme wird die Transmission im sichtbaren Spektralbereich herabgesetzt. Auch eine höhere Menge an leitfähigem Material für die einzelnen Schichten kann eine Verringerung der Transparenz der Verbundscheibe zur Folge haben. Da beispielsweise eine Windschutzscheibe strenge Anforderungen an die Mindesttransparenz erfüllen muss (mindestens 70% Transmission im sichtbaren Spektralbereich nach Regelung 43 der Wirtschaftskommission der Vereinten Nationen für Europa (ECE R 43)), sind der Menge an leitfähigem Material und der Anzahl an Schichten für die funktionellen Filme Grenzen gesetzt.

Zusätzlich muss neben der Transparenz auch das Reflexionsspektrum der Verbundscheibe und weitere Randbedingungen berücksichtigt werden. Dies betrifft insbesondere die Farbwirkung der Verbundscheibe, denn wünschenswert sind in der Regel lediglich Scheiben mit einer grün-blauen Färbung, nicht jedoch einer gelben oder roten Färbung (bezogen auf die Reflexionsfarbe).

Je höher die Anzahl der leitfähigen Schichten ist, desto besser ist gewöhnlich die Beschichtung hinsichtlich eines gewünschten Transmissionsgrads, der Farbgebung oder eines gewünschten Flächenwiderstands optimierbar. Die Beschichtungen als funktionelle Filme, insbesondere mit mehreren Edelmetallschichten sind jedoch zum einen vergleichsweise kostenintensiv und auch in ihrer Einstellbarkeit auf den gewünschten Farbeindruck in Kombination mit der notwendigen Transparenz limitiert. Es wird daher nach Alternativen gesucht die Farbwirkung einer Verbundscheibe, die mit einem oder mehreren funktionellen Filmen ausgestaltet werden soll, zu optimieren.

Aufgabe der vorliegenden Erfindung ist daher die Bereitstellung einer transparenten Verbundscheibe mit mindestens einem funktionellen Film, wobei gleichzeitig mit der durch diesen Film bereitgestellten Funktion, zusätzlich ein verbessertes ästhetisches Erscheinungsbild, insbesondere möglichst frei von unerwünschten Farbtönen in der Reflexion der Verbundscheibe erzielt werden kann.

Die Aufgabe der vorliegenden Erfindung wird erfindungsgemäß durch eine Verbundscheibe gemäß Anspruch 1 gelöst. Bevorzugte Ausführungen gehen aus den Unteransprüchen hervor.

Erfindungsgemäß wird eine Verbundscheibe bereitgestellt, umfassend eine Außenscheibe und eine Innenscheibe, die über eine thermoplastische Zwischenschicht miteinander verbunden sind, wobei die Verbundscheibe mindestens einen funktionellen Film aufweist, der mindestens eine Metallschicht, insbesondere transparente Metallschicht, enthält, und die thermoplastische Zwischenschicht mit mindestens einer thermoplastischen Folie ausgebildet ist, die Brechungsindex-erniedrigende Mittel enthält und durch diese Brechungsindex-erniedrigenden Mittel der Brechungsindex der thermoplastischen Folie im optisch sichtbaren Bereich zwischen 380 nm - 780 nm um mindestens 0,05 (n Δ -0.05) erniedrigt ist.

Mit anderen Worten wird erfindungsgemäß die Zwischenschicht der Verbundscheibe mindestens aus einer thermoplastischen Folie ausgebildet, deren Brechungsindex um mindestens 0,05 (n Δ -0.05) durch Brechungsindex-erniedrigenden Mittel gegenüber dem Brechungsindex n einer thermoplastischen Folie mit einer vergleichbaren Zusammensetzung, aber ohne die erfindungsgemäß eingesetzten Brechungsindex-erniedrigenden Mittel, erniedrigt ist. Gleichzeitig werden die weiteren, beispielsweise optischen oder mechanischen Eigenschaften der Folien und der resultierenden Verbundscheibe, wie zum Beispiel die geforderte Transparenz, Lichttransmission Bruchfestigkeit/Pummelwert oder Verarbeitbarkeit im Wesentlichen beibehalten. Die erfindungsgemäße Verbundscheibe weist hierdurch überraschend einen verbesserten Farbeindruck in der Reflexion auf ohne das weitere Eigenschaften der Verbundscheibe negativ beeinflusst werden.

Die erfindungsgemäße Verbundscheibe umfasst eine Außenscheibe und eine Innenscheibe, die über eine thermoplastische Zwischenschicht miteinander verbunden sind. Die Verbundscheibe ist dafür vorgesehen, in einer Fensteröffnung, insbesondere der Fensteröffnung eines Fahrzeugs, den Innenraum gegenüber der äußeren Umgebung abzutrennen. Mit Innenscheibe wird im Sinne der Erfindung die dem Innenraum (insbesondere Fahrzeuginnenraum) zugewandte Scheibe der Verbundscheibe bezeichnet. Mit Außenscheibe wird die der äußeren Umgebung zugewandte Scheibe bezeichnet. Die Verbundscheibe ist bevorzugt eine Fahrzeug-Windschutzscheibe (insbesondere die Windschutzscheibe eines Kraftfahrzeugs, beispielsweise eines Personen- oder Lastkraftwagens), eine Seitenscheibe oder eine Dachscheibe.

Die Verbundscheibe weist als Windschutzscheibe eine Oberkante und eine Unterkante auf sowie zwei dazwischen verlaufende Seitenkanten. Mit Oberkante wird diejenige Kante bezeichnet, welche dafür vorgesehen ist, in Einbaulage nach oben zu weisen. Mit Unterkante wird diejenige Kante bezeichnet, welche dafür vorgesehen ist, in Einbaulage nach unten zu weisen. Die Oberkante wird häufig auch als Dachkante und die Unterkante als Motorkante bezeichnet. Die Außenscheibe und die Innenscheibe weisen jeweils eine außenseitige und eine innenraumseitige Oberfläche auf und eine dazwischen verlaufende, umlaufende Seitenkante. Mit außenseitiger Oberfläche wird im Sinne der Erfindung diejenige Hauptfläche bezeichnet, welche dafür vorgesehen ist, in Einbaulage der äußeren Umgebung zugewandt zu sein. Mit innenraumseitiger Oberfläche wird im Sinne der Erfindung diejenige Hauptfläche bezeichnet, welche dafür vorgesehen ist, in Einbaulage dem Innenraum zugewandt zu sein. Die innenraumseitige Oberfläche der Außenscheibe und die außenseitige Oberfläche der Innenscheibe sind einander zugewandt und durch die thermoplastische Zwischenschicht miteinander verbunden.

Die Oberflächen der Scheiben werden typischerweise wie folgt bezeichnet: Die Außenseite der Außenscheibe wird als Seite I bezeichnet. Die Innenseite der Außenscheibe wird als Seite II bezeichnet. Die Außenseite der Innenscheibe wird als Seite III bezeichnet. Die Innenseite der Innenscheibe wird als Seite IV bezeichnet.

Die Außenscheibe und die Innenscheibe sind bevorzugt unabhängig voneinander aus Glas oder Kunststoff ausgebildet, bevorzugt Kalk-Natron-Glas, Alkalialuminosilikatglas, Polycarbonat oder Polymethylmethacrylat. In einer besonders bevorzugten Ausgestaltung bestehen die Außenscheibe und die Innenscheibe aus Glas.

Die Außenscheibe und die Innenscheibe sind bevorzugt nicht mechanisch vorgespannt, sie können jedoch in weiteren Ausgestaltungen thermisch vorgespannt oder teilvorgespannt bzw. chemisch vorgespannt sein.

Geeignete Glasscheiben umfassen Glasscheiben, die unter den Handelsnamen Planiclear^{®} und Planilux^{®} (jeweils Klarglas), VG 10, VG 20, VG 40 oder TSANx, TSA3+, TSA4+ von Saint-Gobain bekannt sind, wobei es sich bei den Gläsern der VG-Serie um graugefärbte Gläser und bei denen der TSA-Serie um grüngefärbte Gläser handelt.

Die Außen- und/oder die Innenscheibe weist vorzugsweise unabhängig voneinander eine Dicke von 0,1 bis 4 mm, bevorzugt von 1 bis 4 mm, besonders bevorzugt von 1,6 mm bis etwa 2,1 mm auf.

Die erfindungsgemäße Verbundscheibe weist außerdem mindestens einen funktionellen Film, bevorzugt einen transparenten funktionellen Film auf, der mindestens eine Metallschicht enthält. Dieser funktionelle Film enthält erfindungsgemäß also zumindest ein Metall oder eine Metalllegierung, beispielsweise Silber, Aluminium, Kupfer, Palladium, Platin oder Gold und ist bevorzugt auf Basis des Metalls oder der Metalllegierung ausgebildet, das heißt besteht im Wesentlichen aus dem Metall oder der Metalllegierung abgesehen von etwaigen Dotierungen oder Verunreinigungen.

Der funktionelle Film ist beispielsweise auf der zur Zwischenschicht hingewandten, außenseitigen Oberfläche der Innenscheibe (Seite III) aufgebracht oder auf der zur Zwischenschicht hingewandten, innenraumseitigen Oberfläche der Außenscheibe (Seite II). Der funktionelle Film kann als Beschichtung alternativ innerhalb der Zwischenschicht angeordnet sein. Dazu kann der funktionelle Film auch auf einer Trägerfolie aufbracht sein, beispielsweise aus Polyethylenterephthalat (PET) mit einer Dicke von etwa 20 µm bis 100µm, beispielsweise 50 µm, welche zwischen zwei Lagen thermoplastischen Materials angeordnet ist, beispielsweise zwischen zwei Polymerfolien, beispielsweise PVB-Folien.

Unter einem transparenten funktionellen Film wird eine Schicht oder ein Schichtsystem (Beschichtung) verstanden, die eine mittlere Transmission im sichtbaren Spektralbereich von mindestens 70%, bevorzugt mindestens 75% aufweist, die also die Durchsicht durch die Scheibe nicht wesentlich einschränkt und dabei Funktionen, wie Reflexion für ein HUD-Display, IR-strahlen Reflexion für eine Sonnenschutzbeschichtung bereitstellt oder ermöglicht. Der funktionelle Film kann auch als heizbare Beschichtung ausgestaltet sein, welche elektrisch kontaktiert ist und sich bei Stromdurchfluss erwärmt. Die Transmission im sichtbaren Spektralbereich wird bestimmt gemäß dem durch ECE-R 43, Anhang 3, § 9.1 festgelegten Verfahren zur Prüfung der Lichtdurchlässigkeit von Kraftfahrzeugscheiben.

In einer weiteren Ausführungsform der erfindungsgemäßen Verbundscheibe umfasst der funktionelle Film als transparente Metallschicht mindestens eine Silberschicht, eine Aluminiumschicht, Kupferschicht, Palladiumschicht, Platinschicht oder eine Goldschicht. Erfindungsgemäß bevorzugt ist die mindestens eine Metallschicht eine Silberschicht. Als ein bevorzugtes Metall für die metallische Schicht hat sich Silber durchgesetzt, da es sowohl eine relativ neutrale Farbwirkung besitzt als auch beispielsweise bei der Verwendung als Sonnenschutzschicht die Infrarotstrahlung außerhalb des sichtbaren Bereichs der Sonnenstrahlung selektiv reflektiert.

In einer anderen bevorzugten Ausgestaltung der Verbundscheibe weist der funktionelle Film zwei bis vier Metallschichten, bevorzugt 2, 3 oder 4 Silberschichten auf. Beispielsweise werden Schichtsysteme für Sonnenschutzschichten mit zwei Silberfunktionsschichten, aber auch drei oder vier Silberfunktionsschichten verwendet, da deren Wirkungsgrad, d.h. die Reflexion der Infrarotstrahlung außerhalb des sichtbaren Bereiches im Verhältnis zu Transmission der sichtbaren Strahlung, größer ist. Zudem ist auch die Einstellbarkeit bestimmter Eigenschaften, wie zum Beispiel die Farbwirkung mit größerer Schichtanzahl variabler.

Die metallischen Schichten (Metallschichten), bevorzugt Silberschichten, werden in den funktionellen Filmen üblicherweise zwischen dielektrischen Schichten eingebettet. Mit anderen Worten sind die Metallschichten sandwichartig zwischen dielektrischen Schichten angeordnet.

Die dielektrischen Schichten des funktionellen Films können geeignete, dem Fachmann bekannte Materialien enthalten, beispielsweise mindestens ein Metalloxid wie ZnO, ZnSnOx oder ein Metallnitrid, wie Si₃N₄, oder SiZrNx, oder NiCr. Die dielektrischen Materialien können auch Dotierungen, wie beispielsweise Aluminium aufweisen.

Jede Metallschicht, beispielsweise Silberschicht, ist bevorzugt zwischen zwei dielektrischen Schichten angeordnet. Die Metallschichten und die dielektrischen Schichten sind dabei so angeordnet, dass beispielweise zwischen jeweils zwei benachbarten Silberschichten, zwischen denen keine weitere Silberschicht angeordnet ist, zumindest eine dielektrische Schicht, bevorzugt zwei oder mehr dielektrische Schichten, angeordnet ist und dass oberhalb der obersten Metallschicht, die in Einbaulage der Außenscheibe zugewandt ist, zumindest eine weitere dielektrische Schicht angeordnet ist und dass unterhalb der untersten Metallschicht, die der Innenscheibe zugewandt ist, zumindest eine weitere dielektrische Schicht angeordnet ist. Die dielektrischen Schichten weisen gemäß der Erfindung bevorzugt eine Dicke von 0,1 nm bis 100 nm, besonders bevorzugt von 0,2 nm bis 50 nm, beispielsweise zwischen 0,3 nm und 45 nm auf.

Der erfindungsgemäße funktionelle Film kann beispielsweise als Beschichtung durch physikalische Gasphasenabscheidung (PVD) durch Kathodenzerstäubung ("Sputtern"), ganz besonders bevorzugt durch magnetfeldunterstütze Kathodenzerstäubung, beispielsweise auf die Innenscheibe, aufgebracht sein. Die funktionellen Filme werden bevorzugt als Beschichtungen vor der Lamination auf die Scheiben aufgebracht. Statt die Beschichtung auf eine Scheibenoberfläche aufzubringen, kann sie grundsätzlich auch auf einer Trägerfolie bereitgestellt werden, die in der Zwischenschicht angeordnet wird. Dies kann beispielsweise dadurch erzielt werden, dass in der Herstellung der Verbundscheibe der funktionelle Film zwischen mindestens zwei thermoplastischen Polymerfolien positioniert wird und dann die Polymerfolien durch die Einwirkung von Wärme, beispielsweise bei der Lamination miteinander verschmelzen und den IR-strahlen-reflektierenden Film durch das thermoplastische Material der Folien umflossen und gleichsam eingeschlossen wird. Hierdurch wird der funktionelle Film vor Umwelteinflüssen geschützt.

In einer weiteren Ausführungsform der Verbundscheibe ist der Brechungsindex der thermoplastischen Folie durch die darin enthaltenen Brechungsindex-erniedrigenden Mittel im optisch sichtbaren Bereich (380 nm - 780 nm) zwischen 0,05 und 0,15 erniedrigt. Durch die Erniedrigung des Brechungsindex der thermoplastischen Folie, kann erfindungsgemäß ein verbessertes ästhetisches Erscheinungsbild der Verbundscheibe, insbesondere möglichst frei von unerwünschten Farbtönen in der Reflexion erzielt werden. Es hat sich gezeigt, dass mit stärkerer Verminderung des Brechungsindex der thermoplastischen Folie die Farbwirkung auch stärker in Richtung der gewünschten Farbneutralität, beziehungsweise in Richtung der Verminderung oder Vermeidung unerwünschter gelber und roter Farbtöne der Verbundscheibe beeinflusst werden kann.

In einer bevorzugten Ausgestaltung der Erfindung sind die Brechungsindexerniedrigenden Mittel Nanopartikel, die im optisch sichtbaren Bereich einen Brechungsindex <1,4, bevorzugt < 1,3 bei einer Wellenlänge von 550 nm aufweisen. D.h. die angegebenen Werte für den Brechungsindex sind bei einer Wellenlänge von 550 nm gemessen. Der Brechungsindex kann beispielsweise mittels Ellipsometrie bestimmt werden. Ellipsometer sind kommerziell erhältlich.

In einer weiter bevorzugten Ausgestaltung ist vorgesehen, dass die Brechungsindexerniedrigenden Mittel Metallfluorid Nanopartikel, insbesondere MgF₂, CaF₂, oder hohle SiO₂ Nanopartikel sind, enthalten oder umfassen. Alkalimetallfluoride, mit einem Brechungsindex < 1,4 und Methoden zur Herstellung von Alkalimetallfluoriden, beispielsweise den genannten MgF₂ und CaF₂, sind beispielsweise in K. Scheurell, Inorganics 6,128, 2018 beschrieben. Die alternativ genannten hohlen SiO₂ Nanopartikel werden beispielsweise in M. Gorsd, Procedia Materials Science 8, 567 - 576, 2015 und in T. Gao, Appl. Phys. A 110, 65-70, 2013 offenbart.

In einer weiteren erfindungsgemäßen Ausführungsform sind in der thermoplastischen Folie mindestens 1 Gew.-% Brechungsindex-erniedrigende Mittel, insbesondere Nanopartikel, bezogen auf das Gesamtgewicht der Folie im Volumen der thermoplastischen Folie enthalten sind. Bevorzugt sind dabei 0,5-50 Gew-%; bevorzugt 1 bis 25 Gew. %, 1-10 Gew.-%, beispielsweise bis zu 5-Gew% Brechungsindex-erniedrigende Mittel, insbesondere Nanopartikel, bezogen auf das Gesamtgewicht der Folie im Volumen der thermoplastischen Folie enthalten.

Die Brechungsindex-erniedrigenden Mittel sind erfindungsgemäß bevorzugt Nanopartikel mit einem mittleren Durchmesser von 5 nm bis 200 nm. Die Partikel weisen einen mittleren Partikeldurchmesser von 5 nm bis 200 nm, bevorzugt von < 150 nm, besonders bevorzugt < 100 nm, beispielsweise < 90 nm, <80 nm < 70 nm oder < 50 nm auf. Bevorzugt ist die Partikelgrößenverteilung möglichst homogen, das heißt die eingesetzten Partikel haben möglichst annähernd den gleichen Durchmesser. Im Sinne der Erfindung werden Partikel mit einem mittleren Durchmesser von kleiner oder gleich 500 nm als Nanopartikel bezeichnet. Nanopartikelgrößen können mittels dynamischer Lichtstreuung (DLS) gemessen werden.

In einer weiteren Ausgestaltung der erfindungsgemäßen Verbundscheibe ist die thermoplastische Folie eine Polyvinylbutyral (PVB)-Folie, eine Ethylenvinylacetat (EVA)-Folie oder eine Polyurethan (PU)-Folie, bevorzugt eine PVB Folie. Mit anderen Worten sind die thermoplastischen Folien erfindungsgemäß als thermoplastische Polymerfolien ausgestaltet, die Polyvinylbutyral (PVB), Ethylenvinylacetat (EVA) oder Polyurethan, und/oder Gemische und/oder Copolymere hiervon enthalten. Besonders bevorzugt ist Polyvinylbutyral. Die thermoplastischen Folien sind bevorzugt auf Basis der genannten Materialien ausgebildet, können aber weitere Bestandteile, beispielsweise Weichmacher, enthalten. Die genannten Polymer-Folientypen sind, insbesondere für den Fahrzeugbereich gut geeignet.

Vorteilhafterweise ist es möglich die Brechungsindex-erniedrigenden Mittel, insbesondere nanoskalige Partikel, in solche Polymerfolien einzubringen, ohne dass die weiteren, beispielsweise mechanischen, Eigenschaften der Folien negativ beeinflusst werden. Die thermoplastischen Folien können dabei Standardfolien mit einem erfindungsgemäß durch die Brechungsindex-erniedrigenden Mittel im optisch sichtbaren Bereich zwischen 380 nm - 780 nm um mindestens 0,05 erniedrigten Brechungsindex sein. Die thermoplastischen Folien können dabei klar, gefärbt/getönt (beispielsweise im Falle einer Dachscheibe), mit Farbband aber auch mit weiteren besonderen Eigenschaften oder Funktionen einzeln oder in Kombination ausgestaltet sein. Die thermoplastischen Folien können beispielsweise Keilfolien für die Funktion als Projektionsfläche für ein Head-Up-Display oder Akustikfolien sein.

Bevorzugt weist die thermoplastische Folie der erfindungsgemäßen Verbundscheibe eine Dicke von mindestens 0.1 mm bis maximal 2 mm, bevorzugt 0.2 mm bis 1 mm, besonders bevorzugt 0.3 mm bis 0.8 mm auf. Polymerfolien der Zwischenschicht, insbesondere die PVB-Folien, haben beispielsweise eine Dicke von 0,38 mm, 0,76 mm oder 0,81 mm. Über die Dicke der Folien können weitere Eigenschaften der Verbundglasscheibe beeinflusst werden. So bewirken etwa dickere PVB-Folien eine verbesserte Schalldämpfung, insbesondere wenn sie einen akustisch wirksamen Kern enthalten, einen erhöhten Einbruchswiderstand der Verbundglasscheibe und auch einen erhöhten Schutz gegen ultraviolette Strahlung (UV- Schutz).

In einer anderen bevorzugten Ausführungsform der Verbundscheibe ist vorgesehen, dass die Zwischenschicht aus zwei oder mehr thermoplastischen Folien ausgebildet ist, die einen voneinander verschiedenen Brechungsindex aufweisen. Die optischen Eigenschaften, insbesondere die Farbwirkung in der Reflexion von der Außen- und der Innenseite kann hierdurch nochmals vorteilhaft beeinflusst und auf die gewünschten Werte für die Verbundscheibe optimiert werden.

Weiterhin umfasst die Erfindung ein Verfahren zur Herstellung einer erfindungsgemäßen Verbundscheibe wie sie in verschiedenen Ausgestaltungen vorstehend beschrieben wurde, umfassend die Schritte:
S1: Bereitstellen einer thermoplastischen Folie enthaltend Brechungsindex-erniedrigende Mittel;
S2: Bereitstellen eines funktionellen Films auf der Außenscheibe, der Innenscheibe, auf der thermoplastischen Folie und/oder auf einer Trägerfolie;
S3: Bilden einer Stapelfolge aus Außenscheibe, Innenscheibe und der thermoplastischen Folie sowie ggf. der Trägerfolie;
S4: Verbinden der Stapelfolge unter Einwirkung von Druck, Wärme und/oder Vakuum.

Die thermoplastischen Folien können in Schritt 1 durch an sich bekannte Verfahren hergestellt werden. In einer bevorzugten Ausgestaltung werden die Folien mit die Brechungsindex-erniedrigenden Nanopartikel, die im optisch sichtbaren Bereich einen Brechungsindex <1,4, bevorzugt < 1,3 aufweisen gefertigt. Mit anderen Worten sind die Nanopartikel im Volumen der Folien dispergiert. Die Fertigung der Folien mit den darin dispergierten Nanopartikeln kann beispielsweise in analoger Weise zu den in JP 2002326846 A, US2003/0054160 A1 oder der EP1227070 B1 beschriebenen Verfahren erfolgen.

Vorteilhafterweise ist es möglich die Brechungsindex-erniedrigenden Mittel, insbesondere nanoskalige Partikel, in solche Polymerfolien einzubringen, ohne dass die weiteren, beispielsweise mechanischen, Eigenschaften der Folien negativ beeinflusst werden. Die thermoplastischen Folien können dabei Standardfolien, beispielsweise PVB-Folien ergänzt um die erfindungsgemäßen Brechungsindex-erniedrigenden Mittel sein, die im optisch sichtbaren Bereich (380 nm - 780 nm) den Brechungsindex der Folie um mindestens 0,05 erniedrigen. Die thermoplastischen Folien können dabei klar, gefärbt/getönt, mit Farbband aber auch mit weiteren besonderen Eigenschaften oder Funktionen einzeln oder in Kombination ausgestaltet sein. Die thermoplastischen Folien können beispielsweise Keilfolien für die Funktion als Projektionsfläche für ein Head-Up-Display oder Akustikfolien sein.

In einer weiter bevorzugten Ausgestaltung ist vorgesehen, dass die Brechungsindexerniedrigenden Mittel Metallfluorid Nanopartikel, insbesondere MgF₂, CaF₂, oder hohle SiO₂ Nanopartikel sind, enthalten oder umfassen.

In Schritt S2 kann der funktionelle Film beispielsweise durch physikalische Gasphasenabscheidung (PVD), durch Kathodenzerstäubung (Sputtern) oder durch magnetfeldunterstütze Kathodenzerstäubung auf die Innenscheibe oder die Außenscheibe aufgebracht werden. Bevorzugt werden die funktionellen Filme auf die Innenseite II der Außenscheibe oder die Außenseite III der Innenscheibe aufgebracht Die Beschichtungen werden bevorzugt vor der Lamination auf die Scheiben aufgebracht.

Bevorzugt werden mindestens 80% der Scheibenfläche mit dem funktionellen Film als Beschichtung versehen. Insbesondere ist die Verbundscheibe vollflächig mit der Beschichtung versehen mit Ausnahme eines umlaufenden Randbereichs und optional lokaler Bereich, die als Kommunikations-, Sensor- oder Kamerafenster die Transmission von elektromagnetischer Strahlung durch die Verbundscheibe gewährleisten sollen und daher nicht mit der Beschichtung versehen werden. Der umlaufende unbeschichtete Randbereich kann beispielsweise eine Breite von bis zu 20 cm aufweisen. Dies verhindert den direkten Kontakt der Beschichtung zur umgebenden Atmosphäre, so dass die Beschichtung im Innern der Verbundscheibe vorteilhaft Korrosion und Beschädigung geschützt ist.

Statt die funktionellen Filme als Beschichtung auf eine Scheibenoberfläche aufzubringen, kann sie grundsätzlich auch auf einer Trägerfolie, beispielsweise aus Polyethylenterephthalat (PET) bereitgestellt werden, die in der Zwischenschicht angeordnet wird. Dies kann beispielsweise dadurch erzielt werden, dass in Schritt S3 der Verbundscheibe der funktionelle Film zwischen mindestens zwei thermoplastischen Polymerfolien positioniert wird.

In Schritt S3 werden die Außenscheibe, Innenscheibe und die thermoplastische Folie sowie ggf. die Trägerfolie in üblicher Weise flächig übereinander angeordnet.

Soll die Verbundscheibe gebogen sein, so werden die Außenscheibe und die Innenscheibe bevorzugt vor dem Schritt S4 und bevorzugt nach etwaiger Beschichtungsprozesse in Schritt S2 einem Biegeprozess unterzogen. Bevorzugt werden die Außenscheibe und die Innenscheibe gemeinsam (d.h. zeitgleich und durch dasselbe Werkzeug) kongruent gebogen, weil dadurch die Form der Scheiben für die später erfolgende Laminierung optimal aufeinander abgestimmt sind. Typische Temperaturen für Glasbiegeprozesse betragen beispielsweise 500°C bis 700°C.

Das Verbinden der Außenscheibe und der Innenscheibe über die thermoplastische Zwischenschicht aus der Stapelfolge zur Verbundscheibe in Schritt S4 erfolgt bevorzugt durch Laminieren unter Einwirkung von Hitze, Vakuum und/oder Druck. Es können an sich bekannte Verfahren zur Herstellung einer Verbundscheibe verwendet werden. Beim Laminieren fließt das erhitzte, fließfähige thermoplastische Material um den funktionellen Film herum, so dass ein stabiler Verbund hergestellt wird und die Sonnenschutzbeschichtung in die Zwischenschicht eingekapselt und vor Beschädigung und Umwelteinflüssen geschützt wird.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80°C bis 110 °C. Die Außenscheibe, die thermoplastische Zwischenschicht und die Innenscheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die Scheiben innerhalb von beispielsweise etwa 60 Minuten bei verminderten Drücken von 0,01 mbar bis 800 mbar und Temperaturen von 80°C bis 170°C laminiert werden.

In einer bevorzugten Ausgestaltung des Verfahrens ist vorgesehen, dass die in Schritt S1 bereitgestellte thermoplastische Folie (4B) mit Metallfluorid-Nanopartikeln, insbesondere MgF₂, CaF₂, oder hohlen SiO₂ Nanopartikeln als Brechungsindexerniedrigenden Mitteln ausgebildet ist. Nanopartikel lassen sich in die Folien mit üblichen Verfahren in die Folien integrieren ohne das andere Eigenschaften nachteilig beeinflusst werden.

In einer anderen Ausgestaltung des Verfahrens ist vorgesehen, dass in Schritt S1 zwei oder mehr thermoplastische Folien (4B, 4, 4A) eingesetzt werden, die einen unterschiedlichen Brechungsindex aufweisen. Mit anderen Worten wird hiermit eine Zwischenschicht aus zwei oder mehr thermoplastischen Folien ausgebildet, die einen voneinander verschiedenen Brechungsindex aufweisen. Die optischen Eigenschaften, insbesondere die Farbwirkung in der Reflexion von der Außen- und der Innenseite der Verbundscheibe kann hierdurch nochmals vorteilhaft beeinflusst und auf die gewünschten Werte für die Verbundscheibe optimiert werden.

Die Erfindung umfasst weiterhin die Verwendung der erfindungsgemäßen Verbundscheibe in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheibe und/oder Dachscheibe.

Alle genannten Normen beziehen sich auf deren zum Anmeldetag gültige Fassung.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der Erfindung zu verlassen. Es sei denn Ausführungsbeispiele und/oder ihre Merkmale sind explizit nur als Alternativen genannt oder schließen sich aus.

Nachfolgend wird die Erfindung eingehender unter Bezugnahme auf die Beispiele und Figuren dargestellt. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden, soweit nicht explizit als reine Alternative dargestellt.

Die Zeichnungen sind vereinfachte, schematische Darstellungen und nicht maßstabsgetreu. Die Zeichnungen schränken die Erfindung in keiner Weise ein.

### Beispiele

**Tabelle 1**

| ClimaCoat^{®} mit 4 Silberschichten Laminat | Standard PVB1 Brechungsindex 1,48 | PVB2 Mit niedrigem Brechungsindex (Δ -0.05) | PVB3 mit ultraniedrigem Brechungsindex (Δ-0.13) |
|---|---|---|---|
| TL (A) | 71.7% | 71.6% | 71.4% |
| a* 8° | -7.6 | -7.7 | -7.7 |
| b* 8° | -10.7 | -9.4 | -7.8 |
| a* 60° | +0.9 | -0.2 | -1.4 |
| b* 60° | -5.3 | -4.3 | -3.2 |

Die Tabelle 1 zeigt vergleichend die integralen Werte für eine Verbundscheibe mit einem Flächenwiderstand von ca. 0,7 Ohm, mit einer Standard PVB, die unter dem Handelsnamen ClimaCoat^{®} von Saint Gobain erhältlich ist, zu den Werten von gleich aufgebauten und vergleichbaren Verbundscheiben-Laminaten jedoch einmal mit einer PVB mit niedrigem Brechungsindex (gegenüber der Standard PVB um 0,05 erniedrigt) und einer PVB mit einem ultra niedrigen Brechungsindex (gegenüber der Standard PVB um 0,13 erniedrigt). Die Reflexionswerte werden durch Simulationen mit einem gebräuchlichen optischen Simulationsprogramm bestimmt.

Die angegebenen Farbwerte beschreiben die Reflexionsfarbe der jeweiligen Verbundscheibe und sind auf den L* a* b*-Farbraum (auch: Lab-Farbraum) bezogen, welcher in der EN ISO 11664-4 "Colorimetry -- Part 4: CIE 1976 L* a* b* Colour space" und der neueren DIN EN 410 genormt ist. Die angegebenen Farbwerte a* , b* beziehen sich zumindest auf die außenseitige Reflexionsfarbe unter Bestrahlung mit der Lichtquelle D65 und Einstrahlwinkeln von 8° und 60° (Winkel zur Flächennormalen), gemessen bei Bestrahlung der Außenscheibe mit Strahlung gemischter Polarisation (50% s, 50% p) und Messbedingungen, die in den genannten Normen mit D65/10 spezifiziert sind.

Es zeigt sich das die Außenseitige Reflexion bei 8° mit der zunehmenden Erniedrigung des Brechungsindex weniger blau und bei 60° weniger rot ist. Der Unterschied zu den Farbwerten der Verbundscheibe mit der Standard-PVB-Folie beträgt jeweils mehr als einen Punkt und ist daher als eine signifikante Verbesserung zu werten. Die zu erkennende Tendenz in Richtung einer Farbneutralität mit der Erniedrigung des Brechungsindex der PVB-Folie lässt die Annahme zu, dass eine weitere Senkung des Brechungsindex der eingesetzten PVB-Folie könnte diesen Effekt der verbesserten Farbwirkung in der Reflexion der Verbundscheibe noch verstärken.

**Tabelle 1-1 Schichtaufbau für die Verbundscheiben aus Tabelle 1 mit 4 Metallschichten**

| | Verbundscheibe mit funktionellem Film mit 4 Silberschichten | Schichtdicke |
|---|---|---|
| Außenscheibe1 | Klare Glasscheibe Planiclear^{®} PLC | 2,1 mm |
| Thermoplastische Folie 4 | Standard PVB1 4A (Stand der Technik) oder | 0.737 mm |
| | PVB2 mit erniedrigtem Brechungsindex n(Δ -0.05) 4B(erfindungsgemäß) oder | |
| Thermoplastische Folie 4 | PVB3 mit erniedrigtem Brechungsindex n(Δ -0.13) 4B(erfindungsgemäß) | |
| | Si₃N₄ | 15.8 nm |
| | SiZrNx | 8.1 nm |
| Funktioneller Film 5 | ZnO | 13 nm |
| | NiCr | 0,2 nm |
| | Ag [Metallschicht 6] | 10.9 nm |
| | ZnO | 12.0 nm |
| | ZnSnOx | 10.0 nm |
| | SiZrNx | 21,1 nm |
| | Si₃N₄ | 20.9 nm |
| | ZnO | 16.0 nm |
| | NiCr | 0,2 nm |
| | Ag [Metallschicht 6] | 14.2 nm |
| | ZnO | 14,0 nm |
| | ZnSnOx | 11.0 nm |
| | SiZrNx | 18.4 nm |
| | Si₃N₄ | 17.2 nm |
| | ZnO | 15.0 nm |
| | NiCr | 0,3 nm |
| | Ag [Metallschicht 6] | 13,5 nm |
| | ZnO | 16.0 nm |
| | ZnSnOx | 10.0 nm |
| | SiZrNx | 35.5 nm |
| | ZnO | 16 nm |
| | NiCr | 0,2 nm |
| | Ag [Metallschicht 6] | 11.5 nm |
| | ZnO | 11.0 nm |
| | ZnSnOx | 8.0 nm |
| | SiZrNx | 13.7 nm |
| Innenscheibe 2 | Klare Glasscheibe Planiclear^{®} PLC | 1,6 mm |

In Tabelle 1-1 sind die Schichtaufbauten für die drei Verbundscheiben mit vier Silberschichten wiedergegeben, deren Werte durch Simulation ermittelt wurden, wobei jeweils die Schichtabfolge und die Schichtdicken beibehalten werden und der Unterschied nur im verschiedenen Brechungsindex der jeweils für die Verbundscheibe eingesetzten PVB1 (Standard/Referenz n bei 500 nm 1,48) und der PVB2 (n (Δ -0.05) und der PVB3 (n (Δ -0.13) liegt.

**Tabelle 2**

| ClimaCoat^{®} mit 3 Silberschichten Laminat | Standard PVB1 | PVB2. Mit niedrigem Brechungsindex (n Δ -0.05) |
|---|---|---|
| TL (A) | 72.4% | 72.7% |
| a* 8° | -2.5 | -1,3 |
| b* 8° | -2.9 | -3,1 |
| a* 60° | +0.1 | -0.2 |
| b* 60° | 5.0 | 5.0 |

Die Tabelle 2 zeigt vergleichend die integralen Werte für eine Verbundscheibe mit einem Flächenwiderstand von ca. 0,9 Ohm, mit einer Standard PVB, die unter dem Handelsnamen ClimaCoat^{®} von Saint Gobain erhältlich ist, zu gleich aufgebauten und vergleichbaren Verbundscheiben-Laminaten jedoch einmal mit einer PVB mit niedrigem Brechungsindex (gegenüber der Standard PVB um 0,05 erniedrigt). Bei der Simulation zeigen sich die gleichen Tendenzen, in den Reflexionswerten wie bei den in Tabelle 1 wiedergegebenen Simulationsmessungen, jedoch weniger stark ausgeprägt.

**Tabelle 2-1 Schichtaufbau für die Verbundscheiben aus Tabelle 2**

| | Verbundscheibe mit funktionellem Film mit 3 Silberschichten | Schichtdicke |
|---|---|---|
| Außenscheibe1 | Klare Glasscheibe Planiclear^{®} PLC | 2,1 mm |
| | Standard PVB1 4A (Stand der Technik) oder | |

| Thermoplastische Folie 4 | PVB2 mit erniedrigtem Brechungsindex n (Δ -0.05) 4B(erfindungsgemäß) | 0.76 mm |
|---|---|---|
| Funktioneller Film 5 | SiZrNx | 9.6 nm |
| | Si₃N₄ | 9.9 nm |
| | ZnO | 13 nm |
| | NiCr | 0.2 nm |
| | Ag [Metallschicht 6] | 9.0 nm |
| | ZnO | 14.0 nm |
| | ZnSnOx | 7.0 nm |
| | SiZrNx | 21.5 nm |
| Funktioneller Film 5 | Si₃N₄ | 25.5 nm |
| | ZnO | 10.0 nm |
| | NiCr | 0.3 nm |
| | Ag [Metallschicht 6] | 9.5 nm |
| | ZnO | 9,0 nm |
| | ZnSnOx | 8.0 nm |
| | SiZrNx | 42.1 nm |
| | ZnO | 13 nm |
| | NiCr | 0.2 nm |
| | Ag [Metallschicht 6] | 9.5 nm |
| | ZnO | 13 nm |
| | ZnSnOx | 7.0 nm |
| | SiZrNx | 10.9 nm |
| Innenscheibe 2 | Klare Glasscheibe Planiclear^{®} PLC | 1.6 mm |

In Tabelle 2-1 sind die Schichtaufbauten für die zwei Verbundscheiben mit drei Silberschichten wiedergegeben, wobei die Schichtabfolge und die Schichtdicken beibehalten werden und der Unterschied nur im verschiedenen Brechungsindex der jeweils für die Verbundscheibe eingesetzten PVB1 (Standard/Referenz n bei 500 nm 1,48) und der PVB2 (n (Δ -0.05) liegt.

**Tabelle 3 Schichtaufbau des HUD-Verbundscheiben Laminats**

| HUD Verbundscheiben-Laminat | Standard PVB1 Brechungsindex n 1,48 bei 500 nm | PVB2 mit niedrigem Brechungsindexindex (Δ -0.05) |
|---|---|---|
| TL (A) | 71.9% | 71.5% |
| a*t | -1,5 | -1.3 |
| b*t | 0.6 | 0.9 |
| RL(A) | 22.9 | 23.4 |
| a* 8° | -0.5 | -1.1 |
| b* 8° | 1.8 | 1.0 |
| RL(A) 60° | 28.0 | 28.1 |
| a* 60° | -0.6 | -1.1 |
| b* 60° | 1.1 | 0.5 |
| RL(A) p-pol | 20.1 | 20.1 |
| a* p-pol | 0.6 | 0.4 |
| b* p-pol | 1.1 | 0.3 |
| TTS | 59.7 | 59.7 |
| Polarisationsverhältnis | 1.405 | 1.412 |

Die Tabelle 3 zeigt vergleichend die integralen Werte für eine HUD-kompatible Verbundscheibe (HUD-Verbundscheibe) mit einer Silberschicht (mit einer Standard PVB (PVB1), zu einem gleich aufgebauten und vergleichbaren Verbundscheiben-Laminat jedoch mit einer PVB mit niedrigem Brechungsindex n. PVB2 gegenüber PVB1 ist n um 0,05 erniedrigt (n Δ -0.05).

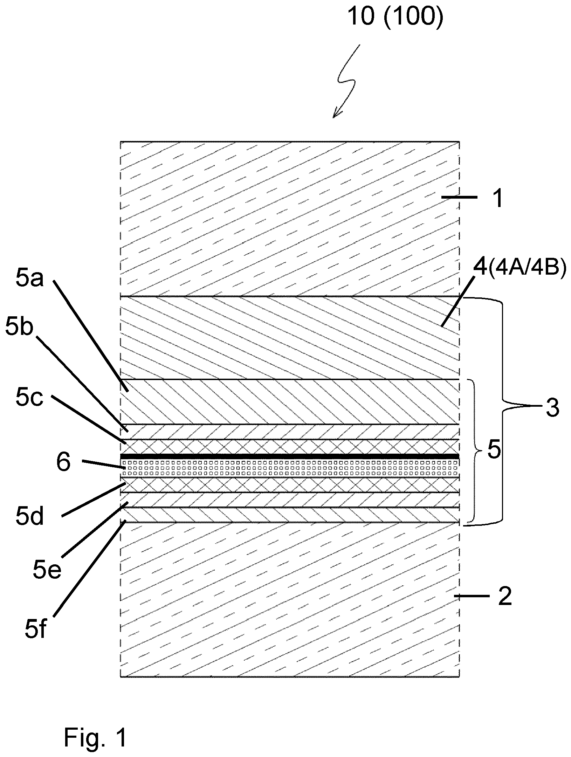

Der Schichtaufbau für die Verbundscheibenlaminate der mit der Simulation mit einem optischen Simulationsprogramm untersucht wurde, ist in Figur 1 und der dazugehörigen Beschreibung wiedergegeben.

Auch in dieser Simulation zeigt sich bei nahezu gleichbleibender Lichttransmission TL(A) und einem identischen TTS Wert (total transmission of solar energy) ein signifikanter Effekt in der Farbwirkung der Verbundscheibe in der Reflexion. Die Reflexionsfarbe bei 8° und 60° wird durch die PVB-Folie mit dem erniedrigten Brechungsindex in den grün-Bereich verschoben. Auch die HUD p-pol Reflexionsfarbe wird mit der PVB mit erniedrigten Brechungsindex farbneutraler. Dies bedeutet, dass bei einer HUD-Projektion eine störende Farbverschiebung vermindert oder vermieden werden kann. Je näher die Farbwerte a* und b* an Null herankommen, desto farbneutraler ist die Farbwirkung in der Reflexion. Überraschend wurde bei dem Vergleich der beiden HUD-Verbundscheiben-Laminate mit dem Einsatz der PVB mit dem erniedrigten Brechungsindex zusätzlich eine um 0.007 erhöhtes Polarisationsverhältnis (p-Polarisation / s-Polarisation) festgestellt. Dieses Verhältnis soll für die Funktionalität von in der Windschutzscheibe integrierten Kamerasystemen möglichst hoch sein.

Die in den Tabellen 1 bis 3 wiedergegebenen Werte sind durch Simulation mit einem optischen Simulationsprogramm erhalten worden.

Es bedeuten:
RL(A) sichtbare externe Reflexion [%] Ein außenseitiges Reflexionsvermögen beschreibt dabei den reflektierten Anteil der von der äußeren Umgebung einfallenden sichtbaren Strahlung.
TL(A) sichtbare Lichttransmission [%] der Verbundscheiben
TTS totale transmittierte Wärmestrahlung [%]
RL(A) 60° sichtbare Reflexion bei einem Betrachtungswinkel von 60[%]
RL(A) p-pol sichtbare p-pol Reflexion [%]
L*, a*, b* Farbkoordinaten (Farbraum CIE, International Commision on Illumination)
Die Werte für die Lichttransmission (TL) und die Reflexion (RL) beziehen sich auf die Lichtart A, das heißt den sichtbaren Anteil des Sonnenlichts bei einer Wellenlänge von 380 nm bis 780 nm.

Es zeigen:
Figur 1 einen schematischen Querschnitt durch einen Schichtaufbau für eine erfindungsgemäße Verbundscheibe am Beispiel eines HUD-kompatiblen Verbundscheiben-Laminats (HUD-Verbundscheibe /HUD-Laminat);
Figur 2 ein Diagramm des Brechungsindex n und Wellenlänge für PVB-Folien mit unterschiedlich erniedrigtem Brechungsindex
Figur 3 die Farbwerte a* b* der Verbundscheiben aus Tabelle 1 mit den thermoplastischen Folien PVB1, PVB 2 und PVB 3 in einem Farbdiagramm.

Figur 1 zeigt einen schematischen Querschnitt durch einen Schichtaufbau 10 für eine erfindungsgemäße Verbundscheibe 100 am Beispiel eines HUD-Laminats, wie es mit dem optischen Simulationsprogramm untersucht wurde. Die Werte für die vergleichenden optisch simulierten Messungen, einmal für eine Verbundscheibe 100 mit einer klaren Standard-PVB Folie 4A, (Stand der Technik) und einmal mit einer klaren PVB Folie 4B mit erfindungsgemäß erniedrigtem Brechungsindex n sind in der Tabelle 3 wiedergegeben. Der Schichtaufbau 10 für die Verbundscheibe 100 umfasst eine Außenscheibe 1, eine Innenscheibe 2 und eine Zwischenschicht 3. Die Innenscheibe 2 und die Außenscheibe 1 sind im Beispiel, welches der optischen Simulation (Tabelle 3) zugrunde gelegt wurde, 2,1 mm Dicke klare Glasscheiben, die beispielsweise unter dem Handelsnamen Planiclear^{®} erhältlich sind Die Zwischenschicht, 3 umfasst eine thermoplastische Folie 4 (4A Stand der Technik/ 4B erfindungsgemäß mit erniedrigtem Brechungsindex n) in den vergleichenden Beispielen aus Tabelle 3 jeweils eine PVB-Folie 4A (PVB1 Standard/Stand der Technik) und PVB-Folie 4B (PVB2/ mit erniedrigtem Brechungsindex) mit einer Dicke von 0,76 mm. Auf der Außenseite III der Innenscheibe 2 zur thermoplastischen Folie 4 (4A/4B) hin gerichtet ist in der Zwischenschicht 3 ein mehrschichtiger, funktioneller Film 5 mit einer transparenten Silberschicht 6 angeordnet. Der funktionelle Film 5 der Beispiel-Verbundscheiben 100, umfasst eine Silberschicht 6 mit einer Dicke von 12,5 nm und weitere dielektrische Schichten (5a, 5b, 5c, 5d,5e, 5f). Der Schichtaufbau für die optischen Simulationen aus Tabelle 3 ist in der Tabelle 4 detailliert wiedergegeben. Der funktionelle Film 5 kann beispielsweise durch übliche Verfahren, wie Sputtern auf die Innenscheibe aufgebracht sein. Es hat sich gezeigt, dass die erfindungsgemäßen Verbundscheiben 100 bei nahezu gleichen Transmissionswerten TL(A) einen signifikanten, positiven Effekt in der Farbwirkung in der Reflexion zeigen. Die Reflexionsfarbe der Verbundscheibe 100 wird durch die erfindungsgemäße PVB-Folie 4B (Tabelle 3, PVB2) mit dem erniedrigten Brechungsindex n in den grün-Bereich verschoben. Auch die HUD p-pol Reflexionsfarbe wird mit der PVB-Folie 4B (PVB2) mit erniedrigten Brechungsindex n farbneutraler. Dies bedeutet, dass bei der Verbundscheibe 100, die erfindungsgemäß mit der PVB Folie 4B mit dem erniedrigten Brechungsindex n gefertigt wurde, bei einer HUD-Projektion eine störende Farbverschiebung im Vergleich zum Stand der Technik (Einsatz der Standard PVB-Folie 4A) vermindert oder vermieden werden kann. Je näher die Farbwerte a* und b* an Null herankommen, desto farbneutraler ist die Farbwirkung in der Reflexion. Überraschend wurde bei dem Vergleich der beiden HUD-Verbundscheiben-Laminate 100 mit dem Einsatz der PVB2 4B mit dem erniedrigten Brechungsindex zusätzlich ein um 0.007 erhöhtes Polarisationsverhältnis (p-Polarisation) festgestellt.

**Tabelle 4 Aufbau einer Verbundscheibe 100 am Beispiel einer HUD-Verbundscheibe mit einer Silberschicht vergleichend mit einer PVB1 (4A) und einer PVB2 (4B) als thermoplastische Folie 4 (4A/4B)**

| | HUD-Verbundscheibe | Schichtdicke |
|---|---|---|
| Außenscheibe1 | Klare Glasscheibe Planiclear^{®} PLC | 2.1 mm |
| Thermoplastische Folie 4 | Standard PVB1 4A (Stand der Technik) oder | 0.76 mm |
| | PVB2 mit erniedrigtem Brechungsindex 4B (erfindungsgemäß) | |
| Funktioneller Film 5 | Si₃N₄ | 50 nm |
| | SiZrNx | 10 nm |
| | ZnO | 10 nm |
| | NiCr | 0.3 nm |
| | Ag [Metallschicht 6] | 12.5 nm |
| | ZnO | 10.0 nm |
| | SiZrNx | 10.0 nm |
| | Si₃N₄ | 10.0 nm |
| Innenscheibe 2 | Klare Glasscheibe Planiclear^{®} PLC | 2.1 mm |

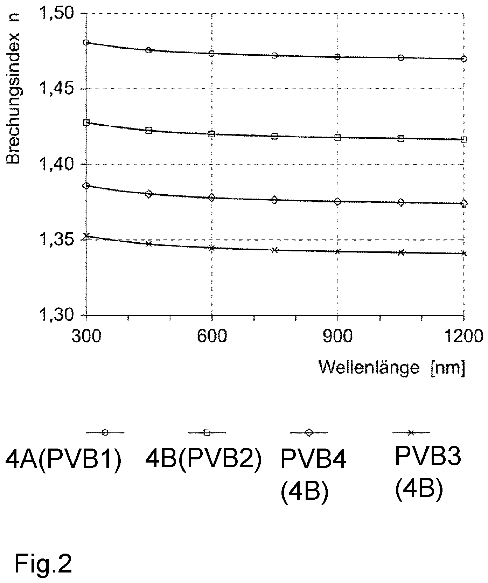

Figur 2 zeigt in einem Diagramm des Brechungsindex n und Wellenlänge für vier PVB-Folien mit unterschiedlich erniedrigtem Brechungsindex. Mit PVB1 (Standard/Referenz /Brechungsindex bei 500nm ca 1,48), PVB 2 (Brechungsindex bei 500nm ca. 1,43; Δ - 0.05) und PVB 3 (Brechungsindex bei 500 nm ca. 1,35; Δ -0.13) wurden die Simulationen durchgeführt, die die in den Tabellen 1 bis 3 wiedergegebenen Werte ergaben. Mit PVB 4 ist eine weitere PVB Folie mit einem Brechungsindex bei 500 nm, von ca.1,39 graphisch dargestellt.

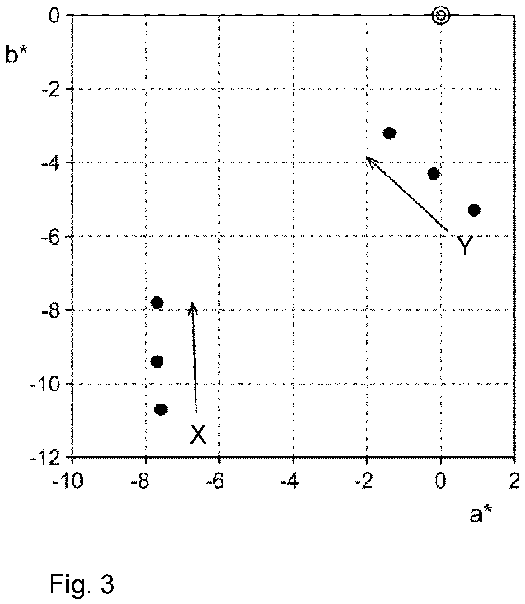

Figur 3 zeigt die mit dem optischen Simulationsprogramm ermittelten Farbwerte a* und b* der Verbundscheiben 100 aus Tabelle 1 mit den unterschiedlichen thermoplastischen Folien PVB1 (Standard/Referenz), PVB 2 (Brechungsindex Δ -0.05) und PVB 3 (Brechungsindex bei 500 nm n Δ -0.13) in einem Farbkoordinatendiagramm a*b*.

Es zeigt sich das die Außenseitige Reflexion bei 8°mit der zunehmenden Erniedrigung des Brechungsindex weniger blau und bei 60° weniger rot ist. Die mit den Pfeilen X (Werte Reflexion bei 8°) und Y (Werte Reflexion bei 60°) im Diagramm dargestellte Tendenz in Richtung einer Farbneutralität mit der Erniedrigung des Brechungsindex der PVB-Folie 4 lässt die Annahme zu, dass eine weitere Senkung des Brechungsindex n der eingesetzten PVB-Folie diesen Effekt der verbesserten Farbwirkung in der Reflexion der Verbundscheibe 100 noch verstärken könnte.

Die erfindungsgemäße Verbundscheibe weist überraschend gute optische und ästhetische Eigenschaften auf, wobei insbesondere unerwünschte Farbtöne in der Reflexion der Verbundscheibe minimiert oder sogar vermieden werden können.

Dies ist erfindungsgemäß möglich ohne das weitere Eigenschaften der Verbundscheibe negativ beeinflusst werden.

Erfindungsgemäß werden also Verbundscheiben mit einem verbesserten Farbeindruck in der Reflexion bereitgestellt. Vorteilhafterweise kann die verbesserte Farbwirkung und der dadurch verbesserte ästhetische optische Eindruck erzielt werden, ohne dass weitere Eigenschaften der Verbundscheibe negativ beeinflusst werden.

### Bezugszeichenliste

- 100: Verbundscheibe
- 10: Schichtaufbau
- 1: Außenscheibe
- 2: Innenscheibe
- 3: Zwischenschicht
- 4: thermoplastische Folie
- 4A: Standard-PVB Folie (Stand der Technik)
- 4B: PVB-Folie 4B (PVB2/ mit erfindungsgemäß erniedrigtem Brechungsindex).
- 5: funktioneller Film
- 5a, 5b, 5c, 5d, 5e, 5f: dielektrische Schichten
- 6: Metallschicht
- I: Außenfläche der Außenscheibe 1
- II: Innenfläche der Außenscheibe 1
- III: Außenfläche der Innenscheibe 2
- IV: Innenfläche der Innenscheibe 2
- X: Tendenz Werte der Reflexion bei 8° mit abnehmendem Brechungsindex der PVB
- Y: Tendenz Werte Reflexion bei 60° mit abnehmendem Brechungsindex der PVB

## Patentansprüche

1. Verbundscheibe (100) umfassend eine Außenscheibe (1) und eine Innenscheibe (2), die über eine thermoplastische Zwischenschicht (3) miteinander verbunden sind, **dadurch gekennzeichnet, dass** die Verbundscheibe (100) mindestens einen funktionellen Film (5) aufweist, der mindestens eine Metallschicht (6) enthält, und die thermoplastische Zwischenschicht (3) mit mindestens einer thermoplastischen Folie (4B) ausgebildet ist, die Brechungsindex-erniedrigende Mittel enthält und durch diese Brechungsindex-erniedrigenden Mittel der Brechungsindex der thermoplastischen Folie (4B) im optisch sichtbaren Bereich zwischen 380 nm - 780 nm um mindestens 0,05 erniedrigt ist.

2. Verbundscheibe nach Anspruch 1 **dadurch gekennzeichnet, dass** der funktionelle Film (5) als Metallschicht (6) mindestens eine Silberschicht Aluminium-, Kupfer-, Palladium-, Platin-, oder eine Goldschicht umfasst.

3. Verbundscheibe nach Anspruch 1 oder 2 **dadurch gekennzeichnet, dass** der funktionelle Film (5) zwei bis vier Metallschichten (6), bevorzugt 2, 3 oder 4 Silberschichten aufweist.

4. Verbundscheibe nach einem der Ansprüche 1 bis 3 **dadurch gekennzeichnet, dass** der funktionelle Film (5) mindestens zwei dielektrische Schichten (5a, 5b, 5c, 5d, 5d, 5e) umfasst, die die Metallschichten (6) sandwichartig einbetten.

5. Verbundscheibe nach einem der Ansprüche 1 bis 4 **dadurch gekennzeichnet, dass** der Brechungsindex der thermoplastischen Folie (4B) durch die darin enthaltenen Brechungsindex-erniedrigenden Mittel im optisch sichtbaren Bereich zwischen 0,05 und 0,15 erniedrigt ist.

6. Verbundscheibe nach einem der Ansprüche 1 bis 5 **dadurch gekennzeichnet, dass** die Brechungsindex-erniedrigenden Mittel Nanopartikel sind, die im optisch sichtbaren Bereich einen Brechungsindex n <1,4, bevorzugt < 1,3 aufweisen.

7. Verbundscheibe nach einem der Ansprüche 1 bis 6 **dadurch gekennzeichnet, dass** die Brechungsindex-erniedrigenden Mittel Metallfluorid-Nanopartikel, insbesondere MgF₂, CaF₂, oder hohle SiO₂ Nanopartikel sind, enthalten oder umfassen.

8. Verbundscheibe nach einem der Ansprüche 1 bis 7 **dadurch gekennzeichnet, dass** in der thermoplastischen Folie (4B) mindestens 1 Gew.-% Brechungsindex-erniedrigende Mittel, insbesondere Nanopartikel bezogen auf das Gesamtgewicht im Volumen der thermoplastischen Folie enthalten sind.

9. Verbundscheibe nach einem der Ansprüche 1 bis 8 **dadurch gekennzeichnet, dass** die brechungsindexerniedrigenden Mittel Nanopartikel mit einem mittleren Durchmesser von 5 nm bis 200 nm sind.

10. Verbundscheibe nach einem der Ansprüche 1 bis 9 **dadurch gekennzeichnet, dass** die thermoplastische Folie (4B) eine Polyvinylbutyral (PVB)-Folie, eine Ethylenvinylacetat (EVA)-Folie oder eine Polyurethan (PU)-Folie, bevorzugt eine PVB Folie ist.

11. Verbundscheibe nach einem der Ansprüche 1 bis 10 **dadurch gekennzeichnet, dass** die thermoplastische Folie (4B) eine Dicke von mindestens 0.1 mm bis maximal 2 mm, bevorzugt 0.2 mm bis 1 mm, besonders bevorzugt 0.3 mm bis 0.8 mm aufweist.

12. Verbundscheibe nach einem der Ansprüche 1 bis 11 **dadurch gekennzeichnet, dass** die Zwischenschicht (3) aus zwei oder mehr thermoplastischen Folien (4B) gebildet ist, die einen voneinander verschiedenen Brechungsindex aufweisen.

13. Verfahren zur Herstellung einer Verbundscheibe (100) nach einem der Ansprüche 1 bis 12, umfassend die Schritte:
S1: Bereitstellen mindestens einer thermoplastischen Folie (4B) enthaltend Brechungsindex-erniedrigende Mittel;
S2: Bereitstellen eines funktionellen Films (5) auf der Außenscheibe (1), der Innenscheibe (2), auf der thermoplastischen Folie (4B) und/oder auf einer Trägerfolie;
S3: Bilden einer Stapelfolge aus Außenscheibe (1), Innenscheibe (2) und der thermoplastischen Folie (4B) sowie ggf. der Trägerfolie;
S4: Verbinden der Stapelfolge unter Einwirkung von Druck, Wärme und/oder Vakuum.

14. Verfahren nach Anspruch 13 **dadurch gekennzeichnet, dass** in Schritt S1 die thermoplastische Folie (4B) als Brechungsindex-erniedrigende Mittel Metallfluorid-Nanopartikel, insbesondere MgF₂, CaF₂, oder hohle SiO₂ Nanopartikel enthält.

15. Verfahren nach Anspruch 13 oder 14 **dadurch gekennzeichnet, dass** in Schritt S1 zwei oder mehr thermoplastische Folien (4B,4) eingesetzt werden, die einen unterschiedlichen Brechungsindex aufweisen.

## Claims

1. Laminated pane (100) comprising an outer pane (1) and an inner pane (2) which are connected to one another via a thermoplastic intermediate layer (3), **characterized in that** the laminated pane (100) has at least one functional film (5) which contains at least one metal layer (6), and the thermoplastic intermediate layer (3) has at least one thermoplastic film (4B) which contains refractive index-reducing media and the refractive index of the thermoplastic film (4B) is reduced by at least 0.05 in the optically visible range between 380 nm - 780 nm by means of these refractive index-reducing media.

2. Laminated pane according to claim 1, **characterized in that** the functional film (5) comprises, as a metal layer (6), at least one silver layer, aluminum layer, copper layer, palladium layer, platinum layer or a gold layer.

3. Laminated pane according to either claim 1 or 2, **characterized in that** the functional film (5) has two to four metal layers (6), preferably 2, 3 or 4 silver layers.

4. Laminated pane according to any of claims 1 to 3, **characterized in that** the functional film (5) comprises at least two dielectric layers (5a, 5b, 5c, 5d, 5d, 5e) which embed the metal layers (6) in a sandwich-like manner.

5. Laminated pane according to any of claims 1 to 4, **characterized in that** the refractive index of the thermoplastic film (4B) is reduced in the optically visible range between 0.05 and 0.15 by means of the refractive index-reducing media contained therein.

6. Laminated pane according to any of claims 1 to 5, **characterized in that** the refractive index-reducing media are nanoparticles which have a refractive index n <1.4, preferably <1.3, in the optically visible range.

7. Laminated pane according to any of claims 1 to 6, **characterized in that** the refractive index-reducing media are, contain or comprise metal fluoride nanoparticles, in particular MgF₂, CaF₂, or hollow SiO₂ nanoparticles.

8. Laminated pane according to any of claims 1 to 7, **characterized in that** the thermoplastic film (4B) contains at least 1 wt.% refractive index-reducing media, in particular nanoparticles, based on the total weight in the volume of the thermoplastic film.

9. Laminated pane according to any of claims 1 to 8, **characterized in that** the refractive index-reducing media are nanoparticles with an average diameter of 5 nm to 200 nm.

10. Laminated pane according to any of claims 1 to 9, **characterized in that** the thermoplastic film (4B) is a polyvinyl butyral (PVB) film, an ethylene vinyl acetate (EVA) film or a polyurethane (PU) film, preferably a PVB film.

11. Laminated pane according to any of claims 1 to 10, **characterized in that** the thermoplastic film (4B) has a thickness of at least 0.1 mm to a maximum of 2 mm, preferably 0.2 mm to 1 mm, particularly preferably 0.3 mm to 0.8 mm.

12. Laminated pane according to any of claims 1 to 11,
**characterized in that** the intermediate layer (3) is formed from two or more thermoplastic films (4B) which have a different refractive index from each other.

13. Method for producing a laminated pane (100) according to any of claims 1 to 12, comprising the steps of:
S1: providing at least one thermoplastic film (4B) containing refractive index-reducing media;
S2: providing a functional film (5) on the outer pane (1), the inner pane (2), on the thermoplastic film (4B) and/or on a carrier film;
S3: forming a stacking sequence from the outer pane (1), inner pane (2) and the thermoplastic film (4B) and, if applicable, the carrier film;
S4: connecting the stacking sequence under the influence of pressure, heat and/or vacuum.

14. Method according to claim 13, **characterized in that** in step S1, the thermoplastic film (4B) contains metal fluoride nanoparticles, in particular MgF₂, CaF₂, or hollow SiO₂ nanoparticles, as refractive index-reducing media.

15. Method according to either claim 13 or 14, **characterized in that** in step S1, two or more thermoplastic films (4B,4) are used which have a different refractive index.

## Revendications

1. Vitrage feuilleté (100) comprenant une vitre extérieure (1) et une vitre intérieure (2) reliées entre elles par l'intermédiaire d'une couche intermédiaire (3) thermoplastique, **caractérisé en ce que** le vitrage feuilleté (100) présente au moins un film fonctionnel (5) qui contient au moins une couche métallique (6), et la couche intermédiaire thermoplastique (3) est réalisée avec au moins un film thermoplastique (4B) qui contient des agents diminuant l'indice de réfraction et, au moyen desdits agents diminuant l'indice de réfraction, l'indice de réfraction du film thermoplastique (4B) est diminué d'au moins 0,05 dans le domaine optiquement visible compris entre 380 nm et 780 nm.

2. Vitrage feuilleté selon la revendication 1 **caractérisé en ce que** le film fonctionnel (5) comprend comme couche métallique (6) au moins une couche d'argent, d'aluminium, de cuivre, de palladium, de platine ou d'or.

3. Vitrage feuilleté selon la revendication 1 ou 2 **caractérisé en ce que** le film fonctionnel (5) présente deux à quatre couches métalliques (6), de préférence 2, 3 ou 4 couches d'argent.

4. Vitrage feuilleté selon l'une des revendications 1 à 3 **caractérisé en ce que** le film fonctionnel (5) comprend au moins deux couches diélectriques (5a, 5b, 5c, 5d, 5d, 5e) qui prennent les couches métalliques (6) en sandwich.

5. Vitrage feuilleté selon l'une des revendications 1 à 4 **caractérisé en ce que** l'indice de réfraction du film thermoplastique (4B) est diminué entre 0,05 et 0,15 dans le domaine optiquement visible au moyen des agents diminuant l'indice de réfraction contenus dans ledit film thermoplastique.

6. Vitrage feuilleté selon l'une des revendications 1 à 5 **caractérisé en ce que** les agents diminuant l'indice de réfraction sont des nanoparticules qui présentent dans le domaine optiquement visible un indice de réfraction n < 1,4, de préférence < 1,3.

7. Vitrage feuilleté selon l'une des revendications 1 à 6 **caractérisé en ce que** les agents diminuant l'indice de réfraction sont, contiennent ou comprennent des nanoparticules de fluorure de métal, en particulier MgF₂, CaF₂, ou des nanoparticules de SiO₂ creuses.

8. Vitrage feuilleté selon l'une des revendications 1 à 7 **caractérisé en ce que** le film thermoplastique (4B) contient au moins 1 % en poids d'agents diminuant l'indice de réfraction, en particulier des nanoparticules, par rapport au poids total dans le volume du film thermoplastique.

9. Vitrage feuilleté selon l'une des revendications 1 à 8 **caractérisé en ce que** les agents diminuant l'indice de réfraction sont des nanoparticules comportant un diamètre moyen allant de 5 nm à 200 nm.

10. Vitrage feuilleté selon l'une des revendications 1 à 9 **caractérisé en ce que** le film thermoplastique (4B) est un film de polybutyral de vinyle (PVB), un film d'éthylène-acétate de vinyle (EVA) ou un film de polyuréthane (PU), de préférence un film PVB.

11. Vitrage feuilleté selon l'une des revendications 1 à 10 **caractérisé en ce que** le film thermoplastique (4B) présente une épaisseur allant d'au moins 0,1 mm à 2 mm maximum, de préférence de 0,2 mm à 1 mm, de manière particulièrement préférée de 0,3 mm à 0,8 mm.

12. Vitrage feuilleté selon l'une des revendications 1 à 11 **caractérisé en ce que** la couche intermédiaire (3) est formée de deux films thermoplastiques (4B) ou plus qui présentent des indices de réfraction différents les uns des autres.

13. Procédé pour la fabrication d'un vitrage feuilleté (100) selon l'une des revendications 1 à 12, comprenant les étapes consistant à :
S1 : mettre à disposition au moins un film thermoplastique (4B) contenant des agents diminuant l'indice de réfraction ;
S2 : fournir un film fonctionnel (5) sur la vitre extérieure (1), la vitre intérieure (2), sur le film thermoplastique (4B) et/ou sur un film de support ;
S3 : former une séquence d'empilement à partir de la vitre extérieure (1), de la vitre intérieure (2) et du film thermoplastique (4B) ainsi que, éventuellement, du film de support ;
S4 : relier la séquence d'empilement sous l'effet de la pression, de la chaleur et/ou du vide.

14. Procédé selon la revendication 13 **caractérisé en ce que,** à l'étape S1, le film thermoplastique (4B) contient, en tant qu'agents diminuant l'indice de réfraction, des nanoparticules de fluorure de métal, en particulier MgF₂, CaF₂, ou des nanoparticules de SiO₂ creuses.

15. Procédé selon la revendication 13 ou 14 **caractérisé en ce que,** à l'étape S1, deux films thermoplastiques (4B,4) ou plus sont utilisés, lesquels présentent des indices de réfraction différents.
